# EUROPEAN PATENT APPLICATION

(11) **EP 1 973 227 A2**
(43) Date of publication of application: **24.09.2008**
(21) Application number: 08152364.9
(22) Date of filing: 06.03.2008
(51) Int. Cl.: H03F 3/60

(54) **Power divider/combiner and power dividing/combining method using the same**

(30) Priority: 19.03.2007 JP 2007069905
(71) Applicant: NEC CORPORATION, Minato-ku, Tokyo 108-8001 (JP)
(72) Inventor: Tanimoto, Takuya, Tokyo Tokyo 108-8001 (JP)
(74) Representative: Vossius & Partner

(57) **Abstract**

A power divider/combiner (1A) include a power n-dividing unit (2A) for dividing a power of an input signal to n divided signals (n: positive integer not less than 2); n phase adjustment units (6A) for adjusting a phase of each of said n divided signals; n amplifiers (7A) for amplifying each of said n divided signals after phase adjustment by said n phase adjustment units; and power combining units (8A) for combining said n divided signals amplified by said n amplifiers and outputting a power combined signal.

## Description

This application is based upon and claims the benefit of priority from Japanese Patent Application No. 2007-069905, filed on March 19, 2007, the disclosure of which is incorporated herein in its entirety by reference.

The present invention relates to a power divider/combiner and a power dividing/combining method using the same.

When electric power of an input signal is smaller than a desired value, power amplification of the input signal is performed. When the input signal is a high-frequency signal of a VHF band and a UHF band used in a television receiver, an FM transmitter or the like and when the input signal is amplified to a desired power with a single amplifier, the amplifier may be saturated and large power loss may occur.

Accordingly, when a high-frequency signal is amplified, the high-frequency input signal is divided into a plurality of signals and each divided signals are amplified, and after that are combined by a combiner.

At this time, when the combiner is a 3dB coupler, it is difficult to set arbitral number of amplifiers. When a combiner of Wilkinson type is used, as a combining number increases, there is a problem that a frequency band becomes extreme narrow. When divided signals are combined, a phase difference occurs between combined signals. Therefore, it may become difficult to obtain power dividing/combining characteristics with a small dividing deviation and a low power loss in whole band area of a broad band. described as Document 1), JP-A-1996-084031 (hereinafter, described as Document 2), JP-A-2005-130013 (hereinafter, described as Document 3), JP-A- 2000-201043 (hereinafter, described as Document 4) and JP-A-1981-114416 (hereinafter, described as Document 5) propose following configurations regarding the problems above-mentioned.

Document 1 discloses an apparatus including a divider which connects with a plurality of directional couplers with different degree of coupling, amplifiers for amplifying a signal and a plurality of combiners including directional couplers. In the apparatus, the divider divides an input signal, and the amplifiers amplify each divided signal. The amplified divided signals are combined by the combiner, and are outputted as one signal. In this case, a plurality of dividers with identical characteristic and a plurality of combiners with identical characteristic are used, and these are arranged in the rotational symmetric positions geometrically. As a result, since a dividing procedure and a combining procedure may be performed in a completely reverse direction with each other, the number of amplifier is not limited and a frequency band does not becomes narrow.

Document 2 discloses an apparatus including a divider for dividing an input signal, a combiner for combining divided signals and a phase adjuster for detecting a direction of a signal phase of signals to be combined based on an unbalanced power which occurs during power combination by the combiner and adjusting the phase in a feedback manner. The phase difference generates the unbalanced power, which becomes a factor of a power loss in.the power combination. Thereby, the power loss is controlled by suppressing phase difference.

Document 3 discloses an apparatus including a divider for dividing an input signal into two signals, a transistor for carrier power amplification installed in one division line, a transistor for peak power amplification installed in the other division line and a combiner for combining the two signals.

In a signal line to which the transistor for carrier power amplification is connected, a first transmission line of quarter-wavelength (hereinafter, described as λ /4) and a first input matching circuit are connected in series to the signal line of an input side of the transistor for carrier power amplification, and a first output matching circuit is connected to the signal line of an output side thereof.

In a signal line to which the transistor for peak power amplification is connected, a second input matching circuit is connected to the signal line of an input side of the transistor for peak power amplification, and a second transmission line of λ/4 and a second output matching circuit are connected in series to the signal line of an output side thereof.

Thereby, even when input impedance and output impedance of the transistor for peak power amplification are not in an open condition, the transistor for peak power amplification can be blocked off well when low-power is outputted and characteristic of the power combination is improved.

Document 4 discloses an apparatus including a divider for dividing an input signal into two signals A1 and B1 and for outputting the signals, a delay line for delaying the divided signal A1 and outputting as a signal A2, a phase device for adjusting a phase of the divided signal B1 and outputting as a signal B2 and a coupler for combining the signal A2 from the delay line and the signal B2 from the phase device.

The phase device includes a 3dB coupler for reflecting an input signal and delaying the input signal for a predetermined time. In the phase device, the divided signal B1 inputted to the 3dB coupler is reflected and becomes the signal B2. A phase of the signal B2 reflected and outputted by the 3dB coupler is later than that of the signal B1. A phase difference of the signal A2 and the signal B2 becomes small due to the delay of the phase.

Document 5 discloses an apparatus including a dividing circuit for dividing an input signal into signals C1 and D1, a delay circuit for delaying a signal C1 and outputting the signal C1 as a signal C2, a variable phase shift device for adjusting a phase of the signal D1 and outputting the signal D1 as a signal D2, a resonator for reflecting a signal, a circulator for sending the signal D2 to the resonator and outputting a reflected signal from the resonator as a signal D3, and a combiner for combining the signal C2 and the signal D3.

When an amount of coupling between the resonator and the circulator is changed, characteristics of the combined signal are adjusted.

An exemplary object of the invention is to provide a power divider/combiner having power dividing/combining characteristics with a small dividing deviation and a low power loss and to provide a power dividing/power combining method using the same.

A power divider/combiner according to an exemplary aspect of the present invention includes a power n-dividing unit for dividing a power of an input signal to n divided signals (n: positive integer not less than 2);n phase adjustment units for adjusting a phase of each of the n divided signals; n amplifiers for amplifying each of the n divided signals after phase adjustment by the n phase adjustment units; and power combining units for combining the n divided signals amplified by the n amplifiers and outputting a power combined signal.

Exemplary features and advantages of the present invention will become apparent from the following detailed description when taken with the accompanying drawings in which:
Fig. 1 is a block diagram of a power n-divider/n-combiner;
Fig. 2 is a block diagram of a power 2-divider/2-combiner;
Fig. 3 is an equivalent circuit of a reactance element;
Fig. 4 is an equivalent circuit of another example of a reactance element;
Fig. 5 is an equivalent circuit of other example of a reactance element;
Fig. 6A is a block diagram of a phase adjustment circuit including lines such as strip lines, coaxial lines or the like;
Fig. 6B is a block diagram of a phase adjustment circuit including two strip lines;
Fig. 7 is a drawing showing a result of simulation for phase characteristics of the power 2-divider/2-combiner;
Fig. 8 is a drawing showing a result of simulation for power loss characteristics of the power 2-divider/2-combiner;
Fig. 9 is a drawing showing a result of simulation for a dividing ratio of the power 2-divider/2-combiner;
Fig. 10 is a block diagram showing a power divider/combiner in a related art;
Fig. 11 is a drawing showing a result of simulation for phase characteristics in the related art;
Fig. 12 is a drawing showing a result of simulation for power loss characteristics in the related art;
Fig. 13 is a block diagram for explaining other problem in the related art; and
Fig. 14 is a drawing showing a result of simulation for a dividing ratio in the related art.

Exemplary embodiments of the present invention will now be described in detail in accordance with the accompanying drawings.

First, technical subjects in electric power dividing/combining technologies are described below.

In the apparatus in the Document 1, it is difficult to perform a power combination with a low power loss in whole band area of a broad band because the divided signal inputted to the combiner includes a large phase difference at a frequency region away from a central frequency.

When signals amplified by the amplifier are combined by the combiner including the directional coupler, a phase difference with 90 degrees may be set up by a line length of a given frequency for suppressing phase difference between signals to be combined. However, this treatment is only applicable to a specific frequency for a phase adjustment , and it is difficult to obtain a low power loss in whole frequency regions over a broad band.

In the apparatus of the Document 1, signals divided in an in-phase manner by the Wilkinson type divider are amplified by the amplifiers operated in parallel and combined by the combiner including the directional coupler. Therefore, because a frequency for a phase adjustment is specified even if a phase difference with 90 degrees is set up for a given frequency, it is difficult to obtain a low power loss in whole frequency regions over a broad band.

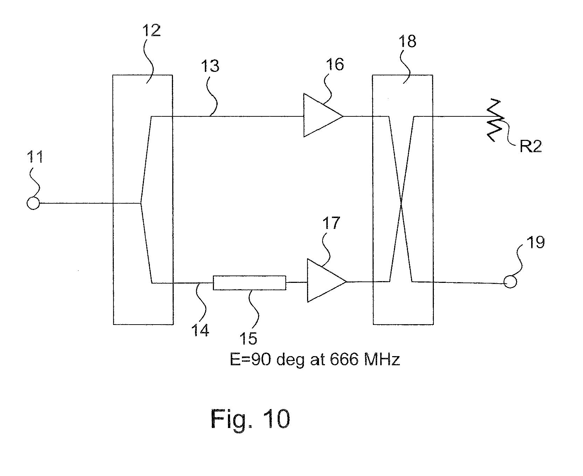

Such problem is described as follows. Fig. 10 is a block diagram of a power divider/combiner in a related art in which a transmission line 15 of an electrical length with 90 degrees at a frequency of 666 MHz is arranged in one of dividing paths.

The power divider/combiner includes a divider 12, the transmission line 15, amplifiers 16, 17 and a combiner 18 including a 3dB coupler of λ/4. A resistance R2 is a terminating resistance.

The divider 12 divides an input signal with a high frequency inputted from an input terminal 11 into two signals 13 and 14. The signal 13 is amplified in the amplifier 16 and enters the combiner 18. On the other hand, the signal 14 whose phase is adjusted in the transmission line 15 is inputted to the amplifier 17. The signal 14 is amplified by the amplifier 17 and is inputted to the combiner 18. The combiner 18 combines the two signals and the combined signals are sent to an output terminal 19.

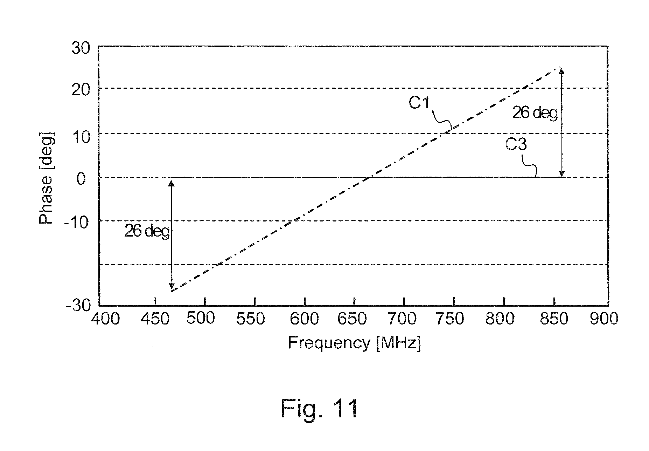

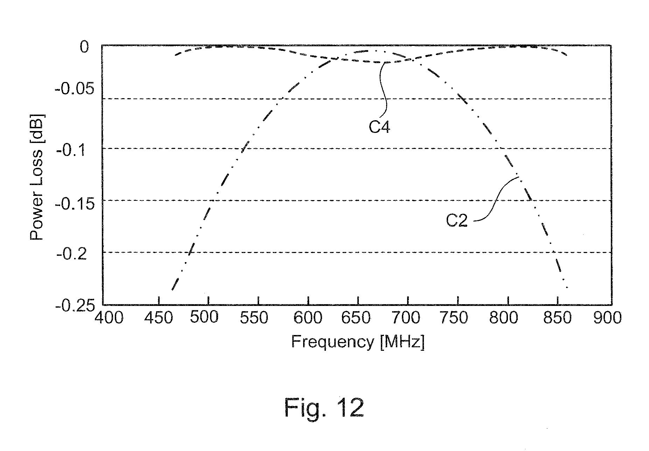

Such power divider/combiner has simulation characteristics as shown in a curved line C1 of Fig. 11 and a curved line C2 of Fig. 12. Fig. 11 shows a phase-frequency characteristic. Fig. 12 shows a power loss characteristic that occurs during dividing/combining.

As shown in the curved line C 1 of Fig. 11, there is a phase difference of ±26 degrees in a frequency region corresponding to an end in a UHF band (470 MHz~862 MHz). As shown in the curved line C2 of Fig. 12, a large power loss of about 0.25 dB occurs in this frequency band.

Therefore, although the phase difference can be reduced at a specific wavelength having a frequency of 650 MHz, for example, the power loss cannot be reduced while reducing a phase difference in whole frequency regions over the broad band.

In the Documents 2, 4 and 5, the phase adjustment of the divided signals for power combination is performed, but the phase adjustment is only applied in a narrow band of frequency. Therefore, a power dividing/combining characteristic of a low power loss can not be obtained in a broadband frequency under a small phase difference, even if the transmission line 15 for phase adjustment as shown in Fig. 10 is used.

In the Document 3, because a phase adjustment means is not set up, a phase difference becomes large when the directional coupler including the 3dB coupler of λ/4 is used as a divider.

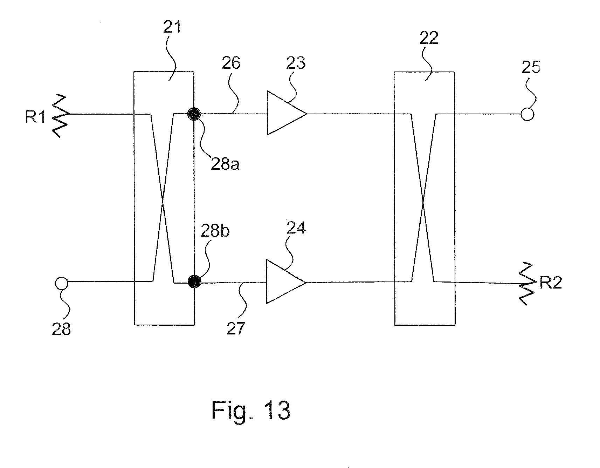

Fig. 13 is a block diagram of a power divider/combiner in the related art. The power divider/combiner includes a divider 21, two amplifiers 23, 24 which operate in parallel, and a combiner 22. R1 and R2 are terminating resistances.

Each of the divider 21 and the combiner 22 includes a cross coupling of the 3dB couplers of λ/4 so that a power division/combination can be performed for signals in a broadband frequency. The divider 21 divides a signal inputted from an input terminal 28 into two signals 26, 27 and outputs the two signals to output terminals 28a and 28b. The signal 26 is amplified in the amplifier 23, and the signal 27 is amplified in the amplifier 24. The amplified signals 26, 27 are inputted to the combiner 22 and outputted to an output terminal 25.

Such power divider/combiner shows simulation characteristics shown by a curved line C3 of Fig. 11 and a curved line C4 of Fig. 12.

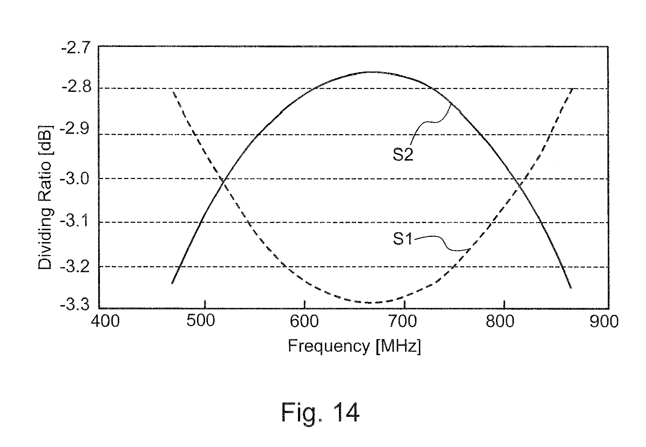

The power divider/combiner of Fig. 13 shows an excellent phase characteristic and an excellent power loss characteristic in the UHF broad band, compared with the power divider/combiner shown in Fig. 10. However, in the divided signals 26 , 27 in the power divider/combiner of Fig. 13, a dividing ratio up to 0.5 dB arises in the UHF band as shown in Fig. 14. That is, a deviation occurs between signal levels of the divided signals 26 and 27.

In Fig. 14, a curved dotted line S1 indicates a dividing ratio from an input terminal 28 of the divider 21 to an output terminal 28a thereof, and a curved solid line S2 indicates a dividing ratio when looking at an output terminal 28b from an input terminal 28. Therefore, because a difference in the dividing ratios of the divided signals 26, 27 inputted to each of the amplifiers 23, 24 is up to 0.5 dB even when the amplifiers 23, 24 are operated in parallel, a difference in the levels of signals outputted therefrom also occurs.

Next, an exemplary embodiment of the present invention based on such consideration is described below.

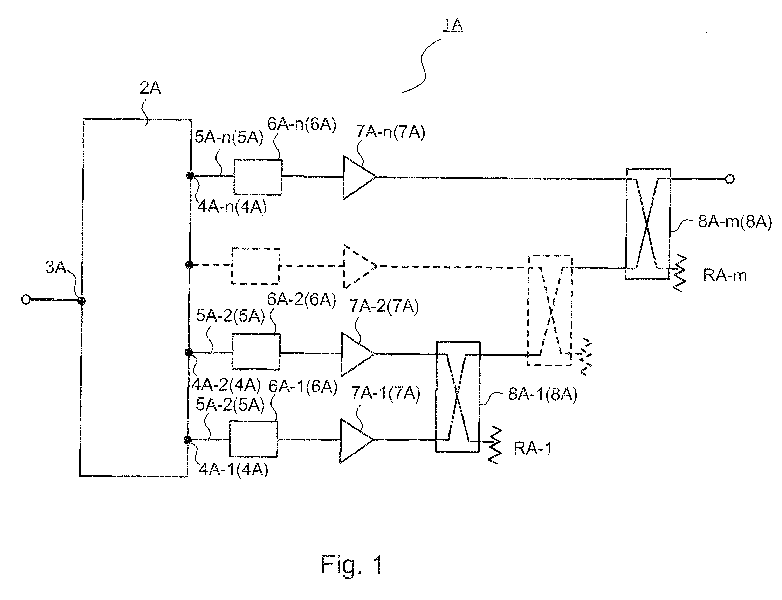

Fig. 1 is a block diagram of a power n-divider/n-combiner 1A of the exemplary embodiment. The power n-divider/n-combiner 1A includes a divider 2A which is a Wilkinson type n-divider, phase adjustment circuits 6A (6A-1~6A-n), amplifiers 7A (7A-1~7A-n) and directional couplers 8A (8A-1~8A-m) including a transmission line of λ/4.

One terminal for each of directional couplers 8A (8A-1~8A-m) is terminated by one of terminating resistances RA (RA-1~RA-m). The divider 2A includes an input terminal 3A and output terminals 4A (4A-1~4A-n), and divides an input signal inputted from the input terminal 3A into in-phase signals 5A (5A-1~5A-n). The input signal is, for example, a high-frequency signal of the VHF band or the UHF band.

Here, suffix n is positive integer which is equal to two or more than two, and m is positive integer which is n-1. In following descriptions, a plurality of elements which perform the same operation, for example, phase adjustment circuits 6A-1~6A-n or the like, are represented by the phase adjustment circuit 6A.

The phase adjustment circuit 6A includes a transmission line or reactance elements such as inductors and capacitors, and performs a phase adjustment for divided signals 5A. Each of the amplifiers 7A which operates in parallel amplifies each divided signal 5A phase-adjusted.

The directional couplers 8A combine each amplified divided signals 5A. Each of the directional couplers 8A (8A-1~8A-m) is connected in cascade connection. The cascade connection means a connection in which a plurality of directional couplers are connected in series such that one output signal of a directional coupler becomes a input signal of a posterior directional coupler, and an output signal of the posterior directional coupler becomes an input signal of a further posterior directional coupler.

Since the n-divider of Wilkinson type is used as a divider, each dividing ratio in divided signals can be set to an equal level. Therefore, variation in levels of signals outputted from amplifiers 7A is suppressed. Since phase adjustment is performed in each of phase adjustment circuits 6A for divided signals 5A respectively, phase difference in each of divided signals can be reduced in whole frequency area of a broad band. At least, a phase difference of two divided signals inputted to each of the directional couplers 8A (8A-1~8A-m) is adjusted for each thereof. Therefore, a power loss which occurs during combining divided signals can be reduced.

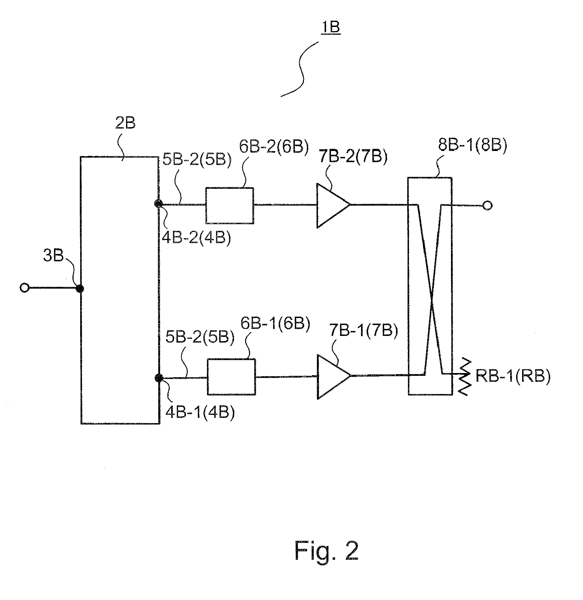

Next, a specific example of the power n-divider/n-combiner 1A will be described. Fig. 2 shows a block diagram of a power 2-divider/2-combiner 1B which divides an input signal into two signals and combines the two signals.

The power 2-divider/2-combiner includes a divider 2B which is a Wilkinson type 2-divider, phase adjustment circuits 6B (6B-1 and 6B-2), two amplifiers 7B (7B-1 and 7B-2) which operate in parallel and a directional coupler 8B (8B-1) including a transmission line of λ/4.

One terminal for the directional coupler 8B (8B-1) is terminated by a terminating resistance RB (RB-1). The divider 2B includes an input terminal 3B and two output terminals 4B (4B-1 and 4B-2). The divider 2B divides an input signal inputted from the input terminal 3B into two equal in-phase divided signals 5B (5B-1 and 5B-2). The input signal is, for example, a high-frequency signal of the VHF band or the UHF band.

Since the Wilkinson type 2-divider is used, each of dividing ratios in divided signals can be equalized. Therefore, variation in levels of signals outputted from amplifiers 7B (7A-1 and 7B-2) is suppressed. Since phase adjustment is performed for divided signals 5B in phase adjustment circuits 6B respectively, a phase difference between divided signals can be reduced in a broad band. At least, a phase difference in the two divided signals which enter the directional coupler 8B is adjusted for each directional coupler 6B. Therefore, a power loss which occurs during combining divided signals can be reduced.

The phase adjustment circuits 6A, 6B can include either reactance elements or a transmission line. In a following example, the phase adjustment circuits 6B-1 and 6B-2 shown in Fig. 2 include reactance elements and a transmission line respectively.

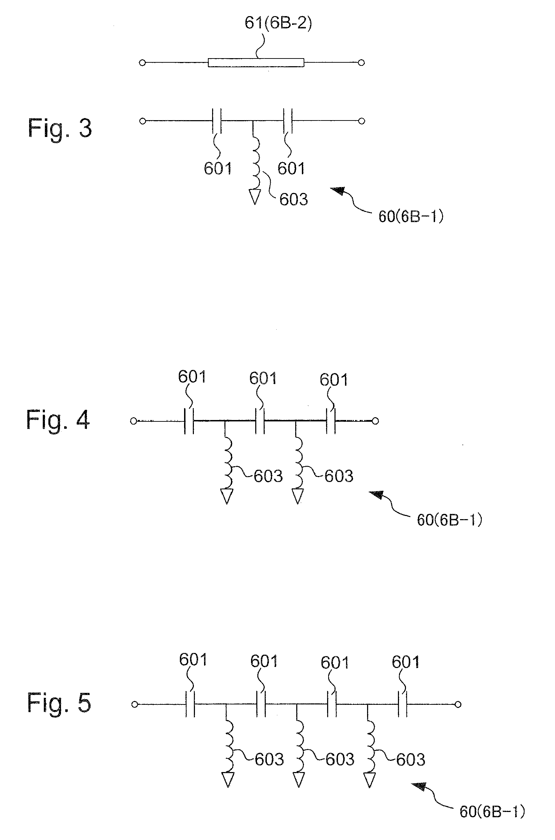

Fig. 3 shows an equivalent circuit including the reactance element 60 (6B-1) and the transmission line 61 (6B-2). The reactance elements 60 is a three terminal circuit including two capacitors 601, 601 connected in series and an inductor 603 connected between a connection point thereof and a grounding point. Further, a grounding point may be a predetermined potential.

In the present invention, the reactive elements 60 having two capacitors and one inductor is not necessarily essential. As shown in Figs. 4 and 5, a configuration including a plurality of capacitors and a plurality of inductors is also usable. Fig. 4 shows a configuration having three capacitors and two inductors, and Fig. 5 shows a configuration having four capacitors and three inductors.

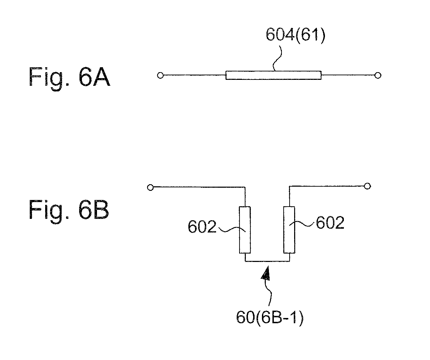

Actual phase adjustment circuits 6A and 6B can be composed using strip line and coaxial line having the self-inductances without using a capacitor and an inductor. Fig. 6A shows an example of the transmission line 61 including a line 604 such as a strip line with self-inductance and a coaxial line. Fig. 6B shows an example of the reactance elements 60 in which two strip lines 602 of a predetermined length having self-inductance are located close to each other in a parallel manner. Since high-frequency signals flow in the strip lines 602, the strip lines 602 located close to each other are coupled by capacity coupling. Thus, a capacitor is not necessary.

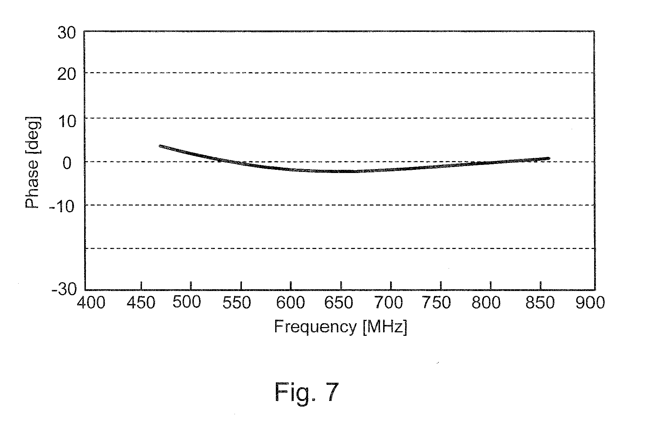

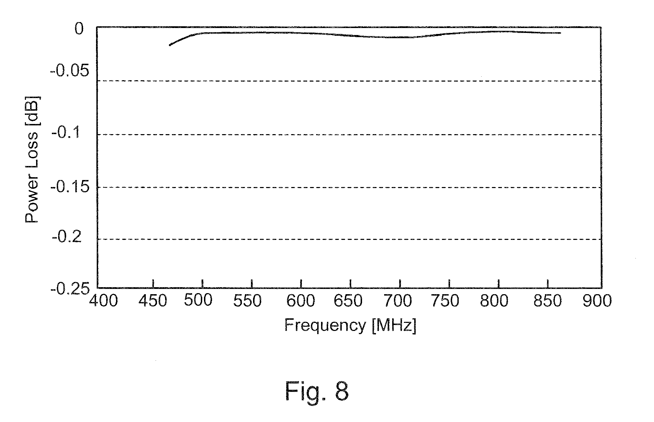

Fig. 7 shows a result of simulation of a phase characteristic of the power 2-divider/2-combiner 1B including the phase adjustment circuits 6B-1 and 6B-2 shown in Fig. 2. The phase adjustment circuit 6B-1 includes the reactance element having a capacitor of 12 Farad capacitance and a inductor of 18 nano Henry inductance. The phase adjustment circuit 6B-2 includes a transmission line having electrical length of 45 degrees at 666 MHz which is the center frequency of the UHF band (470 MHz-862 MHz). Fig. 8 shows a result of simulation of a power loss characteristic for the power 2-divider/2-combiner 1B. In the simulations, no phase difference between the amplifiers 7B-1 and 7B-2 occurs.

The phase difference in an end region of the UHF band (470 MHz-862 MHz) is a very small value which is within ±5 degrees. The power loss is very small all over the bands.

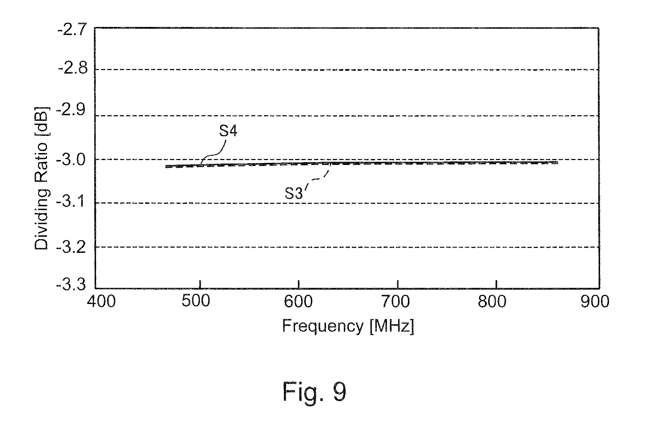

Fig. 9 shows the dividing ratio of the divided signals 5B-1 and 5B-2 in the power 2-divider/2-combiner 1B shown in Fig. 2. The dividing ratio is smaller than 0.02 dB. In Fig. 9, a dotted line S3 shows the dividing ratio from an input side of the directional coupler 8B and a solid line S4 shows the dividing ratio from an output side thereof.

Further, the invention is not limited to the above-mentioned description. As far as each phase of the divided signals matches at a combiner side and deviation of a level of the divided signal to the amplifier does not vary greatly (the deviation is within ±0.2 dB practically), phase adjustment circuits may be constituted by only transmission lines or only reactance elements.

In the phase adjustment circuit, when a coupler is located at the combiner side, a reactance element is selected so that a phase difference of divided signals may satisfy a condition of 90±10 degrees in all over the frequency band of input signals.

As described above, after phase adjustment for each n-divided signal is performed so as to adjust a phase difference therebetween, the n-divided signals are amplified and combined. Therefore, an excellent power dividing/combining characteristic in whole frequency area of a broad band can be obtained.

The dividing deviation of the divider can be reduced over a wide band by combining the phase adjustment circuit and the combiner including the coupler, compared with that in the divider including the directional coupler of λ/4.

While the invention has been particularly shown and described with reference to exemplary embodiments thereof, the invention is not limited to these embodiments. It will be understood by those of ordinary skill in the art that various changes in form and details may be made therein without departing from the spirit and scope of the present invention as defined by the claims.

Further, it is the inventor's intention to retain all equivalents of the claimed invention even if the claims are amended during prosecution.

## Claims

1. A power divider/combiner, comprising:
a power n-dividing unit (2A) for dividing a power of an input signal to n divided signals (n: positive integer not less than 2);
n phase adjustment units (6A) for adjusting a phase of each of said n divided signals;
n amplifiers (7A) for amplifying each of said n divided signals after phase adjustment by said n phase adjustment units (6A); and
power combining units (8A) for combining said n divided signals amplified by said n amplifiers (7A) and outputting a power combined signal.

2. The power divider/combiner according to claim 1, wherein
said input signal inputted to said power n-dividing unit is a high-frequency signal in one of a VHF band and a UHF band.

3. The power divider/combiner according to claims 1 , wherein
said power n-dividing unit includes a Wilkinson type divider and said power combining units includes a coupler type combiner.

4. The power divider/combiner according to claim 1 or 2, wherein
said phase adjustment units includes at least one of a transmission line for phase adjustment and a reactance element.

5. The power divider/combiner according to claim 4, wherein
said phase adjustment units includes a first capacitor and a second capacitor connected in series between an input terminal and an output terminal, and
an inductor connected between a intermediate position of said first and second capacitors and a position having predetermined potential.

6. The power divider/combiner according to claim 4 or 5, wherein
said phase adjustment units includes a first strip line and a second strip line each having a predetermined length located close to each other.

7. The power divider/combiner according to claim 3, 4, 5 or 6, wherein
said coupler type combiner includes a plurality of directional couplers connected in a serial manner.
